Europäisches Patentamt

European Patent Office

Office européen des brevets

(19)

(11) Publication number: **0 154 187 B1**

# EUROPEAN PATENT SPECIFICATION

(12)

(45) Date of publication of patent specification: **29.05.91**  (51) Int. Cl.⁵: **H01L 23/48**, H01L 21/60

(21) Application number: **85101301.1**

(22) Date of filing: **07.02.85**

(54) Tape bonding material and structure for electronic circuit fabrication.

(30) Priority: **08.03.84 US 587433**

(43) Date of publication of application:
**11.09.85 Bulletin 85/37**

(45) Publication of the grant of the patent:
**29.05.91 Bulletin 91/22**

(84) Designated Contracting States:
**BE DE FR GB IT NL**

(56) References cited:
EP-A- 0 061 863       DE-A- 2 546 443
DE-A- 2 725 260       FR-A- 2 368 125
FR-A- 2 375 721       US-A- 3 544 857
US-A- 3 568 301       US-A- 3 868 724

PATENTS ABSTRACTS OF JAPAN, vol. 7, no.
129 (E-179)[1274], 4th June 1983; & JP-A-58
44 759 (NIPPON DENKI K.K.) 15-03-1983

(73) Proprietor: **Olin Corporation
427 North Shamrock Street
East Alton Illinois 62024(US)**

(72) Inventor: **Butt, Sheldon H.
1904 Arrowhead Lane
Godfrey Illinois 62035(US)**

(74) Representative: **Klunker, Hans-Friedrich, Dr. et
al
Patentanwälte Klunker . Schmitt-Nilson .
Hirsch Winzererstrasse 106
W-8000 München 40(DE)**

EP 0 154 187 B1

## Description

The present invention relates to an electronic circuit assembly.

While the invention is subject to a wide range of applications, it is especially suited for electrically connecting integrated circuits to lead frames and will be particularly described in that connection.

Tape Automated Bonding (TAB), an alternative to wire bonding, is a technique of interconnecting bonding pads on a semiconductor device with a lead frame or the equivalent lead pattern in Leadless Ceramic Chip Carriers (LCCC).

In Tape Automatic Bonding, a lead pattern is etched from a relatively thin metal foil or tape into a desired configuration. The tips of the metal fingers are bonded to the bonding pads on a semiconductor die. The other end of the fingers are bonded to the leads on a lead frame. Upon completion of the bonding step, any remaining metal is removed. The result is a multiplicity of substantially rectangular wires connecting the die to the lead frame.

U.S. Patent No. 4,330,790 to Burns discloses a typical TAB package. Also, a description of new technology with respect to chip carriers and TAB is presented in an article entitled "Chip-Carriers, Pin Grid Arrays Change The PC-Board Landscape" by Jerry Lyman, Electronics, December 29, 1981, Pages 65-75.

Tape Automated Bonding has two particular advantages. Firstly, all of the bonds between the tape and the lead frame and between the tape and the bonding pads on the die are fabricated in a single operation rather than the multiple operations required in wire bonding individually wires.

Secondly, the tape is produced from very thin foil, commonly having a thickness from between about .0014 to about .0042" (about 0.035 mm to about 0.11 mm). This permits the formation of very narrow internal tips of the TAB leads. They may be constructed to be narrower than the flattened ball formed in the ball bonding operation for wire bonding. This allows the possibility of using narrower bonding pads around the periphery of the die than possible where ball bonding is used. This is extremely advantageous in the case of semiconductor devices which require a relatively large number of interconnections such as a complex microprocessor which may require over a hundred and fifty of such interconnections.

The tape may be a single layer of etched foil, such as copper. Other possibilities include two or three layer tape. The layer tape is constructed of a layer of plastic film applied to one or both sides of the etched foil to provide features such as added support or a handling mechanism. This film may be a polyimide film of about 1 to 2 mils (0.025 mm to 0.05 mm) in thickness. With layer tape, portions of the plastic film are removed before lamination to the etched tape in order to leave the metal exposed for bonding.

In a conventional semiconductor die, the bonding pads around the periphery of the die are essentially flush with the top surface of the die. For processing considerations, they do not extend out quite to the edge of the die. If flat tape is bonded directly to the flush bonding pads on the die, the tape may contact the outer periphery of the die as well as the pad and cause a short circuit. This potential problem can be dealt with in two ways. The most conventional method is to bump the bonding pad on the die by raising its surface somewhat above the general surface level of the die. This acts to raise the tape safely above the edge of the die. An alternative which is now becoming popular is to bump the tape and use a flat die without a raised pad.

Commonly, one or two ounce thickness copper foil ( .0014" or .0028" (0.035mm or 0.07mm) is used on flat TAB foil while two or three ounce copper foil is used on bumped or B-TAB foil. The extra thickness in the B-TAB foil is required to leave metal from which the bump is fabricated while etching away the material in the remainder of the foil.

When TAB or B-TAB are used in a plastic encapsulated device, the next step following tape bonding and removal of surplus material is to encapsulate the device in plastic. Commonly, this is performed by placing the preassembled lead frame, tape and semiconductor die in a mold and transfer mold an epoxy around the die tape and lead frame. The plastic or epoxy, a relatively viscous material, flows laterally into the mold and subjects the bond between the tape and the die, as well as the lead frame and the tape itself to substantial shear forces. These shear forces are strong enough to break the bond or deform the finger elements between the die and the lead frame. A short circuit may result if the adjacent fingers come into contact with each other or are sufficiently close so as to permit flow of current between the two adjacent fingers. The fingers could also be deformed enough to contact the edge of the die despite the bump and thereby cause a short circuit.

These factors impose some design limitations upon the use of the TAB. Everything else being equal, the longer the span between the die and the lead frame which the tape must bridge, the greater the shear forces which must be dealt with in encapsulation. Increased shear forces increase the stress on the bonds and also increase the stress tending to deform the fingers. The stress on the bonds may be reduced by decreasing the cross section of the fingers. However, this may have a negative result because the fingers become easier to permanently deform. If the cross section of the fingers is increased in order to increase their resistance to deformation, the stress on the bonds also increase.

A higher strength material is of potential advantage since, for equal resistance to finger deformation, it would permit the use of a finger of smaller dimensions. Alternatively, it would permit a longer span between the bonding pad and the lead frame. The longer span could have a smaller cross section than would otherwise be required to avoid finger deformation. Such a cross section would enable the shear forces upon the bonds to be kept within tolerable limits over a longer span.

The ability to form relatively longer span could be advantageous in a lead frame having a large number of leads. The minimum width of the internal ends of the leads is limited by the thickness of the lead frame material as is also the minimum spacing between the leads. Generally, the stamping rules dictate that the distance between the fingers being pierced out cannot be much less than the thickness of the material. For example, a lead frame having a thickness of .010" (0.25mm) can tolerate the tips having a minimum width of approximately .010" (0.25 mm) and a minimum spacing between the leads of approximately .010" (0.25 mm). These size factors limit the minimum size of the central periphery defined by the lead tips. The minimum size of the central periphery and the maximum permissible span between the lead tips and the bonding pads on the die define the minimum die dimensions which may be used with a lead frame having a given number of leads and a given thickness. As the size of complex semiconductor devices decreases, the minimum die size required by the limitations on the lead frame geometry and the interconnection span is greater than the minimum geometry required to accommodate the functions on the semiconductor chip. The chip in effect, becomes larger in its overall dimensions than required. Also, there are die designs in which it would be advantageous to interconnect to a position on the die other than around the periphery if only a longer span could be tolerated.

The essentials of interconnection bonding are basically the same as in other types of metallurgical bonding. Through a combination of differential movement of the two elements to be bonded, a metallurgical bond is formed. The bonding parameters may be advantageously influenced by the application of heat and pressure (thermocompression bonding), by a combination of heat and ultrasonic energy (thermosonic bonding) or by substantial input of ultrasonic energy (ultrasonic bonding).

The physical characteristics of the lead frame surface to which an interconnection is to be bonded are established by the functional requirements of the lead frame. These include high strength, solderability and high electrical conductivity. Also, the characteristics of the lead frame may be modified by a clad or plated coating which may be added to the lead frame material. These include materials such as copper or silver plating or cladding. The lead frame itself may be formed of materials such as copper or nickel alloys.

The characteristics of the bonding pads on the semiconductor die are limited to those which may be obtained during the deposition of a single or multiple layers of metallization used in creating the pad. There is a further limitation which limits the maximum unit pressure that can be used in bonding to the die so as to avoid fracture of the underlying brittle silicon die material. It can be appreciated that the optimum physical characteristics of one end of the tape finger (which is bonded to the lead frame) may be quite different from the optimum characteristics of the other end of the TAB finger (which may be bonded to the semiconductor die). The choice of the interfacial material to be used in the tape may be selected so as to avoid the formation of undesirable intermetallics between the tape and the lead frame or between the tape and the bonding pad. For instance, the bonding of copper and copper alloy members to members containing aluminum often result in the formation of copper-aluminum intermetallic compounds. These copper-aluminum intermetallic compounds tend to be brittle and degrade the integrity of the bond between the members. They may also adversely affect the electrical conductivity characteristics of the bonded members. To avoid formation of these intermetallic compounds, semiconductor manufacturers have added a silver plated stripe in the area where the aluminum member, such as a lead wire, is to be bonded to a copper member, such as a lead frame. In lieu of a silver plated stripe, a nickel plated surface has also been used.

EP-A-0116 844 (not pre-published) discloses copper alloys which may be bonded to aluminum containing members so as to reduce the formation of undesirable copper-aluminum intermetallic compounds.

It is the problem underlying the present invention to provide an electronic circuit using tape bonding material, which is subject to relatively high temperatures, is bondable to both a lead frame as well as a semiconductor chip and is resistant to intermetallic formations.

This problem is solved in accordance with the features of claim 1.

It is an advantage of the invention that the electronic circuit assembly uses tape bonding material which is a high strength material.

It is another advantage of the invention that the tape bonding material is suitable for dissipating heat from a semiconductor die to which it is affixed.

Accordingly, there has been provided an electronic circuit assembly comprising a semiconductor die having an aluminum terminal pad on its top surface. A lead frame disposed adjacent the semiconductor die is adapted to be electrically connected to the semiconductor die. An electrical connection device interconnects the terminal pad to the lead frame. The electrical connection device includes a transport tape comprising a first member formed from a nickel containing material and a second member formed from a copper containing material. The first and second members are bonded together. The transport tape is disposed in the electronic circuit assembly with its first member bonded to the aluminum terminal pad and its second member bonded to the lead frame.

In another embodiment of the present invention, the transport tape serves to efficiently dissipate heat from the semiconductor die.

The invention and further developments of the invention are now elucidated by means of preferred embodiments shown in the drawings:

Figure 1 is a schematic representation of an electronic circuit assembly including a tape bonding material comprising two different components bonded together;

Figure 2 is a schematic representation of a bumped tape bonding material in accordance with the present invention;

Figure 3 is a schematic representation of a tape bonding material comprising three different materials clad together;

Figure 4 is a schematic representation of a triclad tape bonding material wherein two of the claddings are only on either end of the metal finger;

Figure 5 is a schematic representation of a section of tape material having the lead fingers stamped in;

Figure 6 is a schematic representation of a conventional lead frame;

Figure 7 is a schematic representation of a tape bonding material structure which is suitable for dissipating heat from the surface of a semiconductor die;

Figure 8 is a schematic representation of only the thermal dissipation leads of a stamped tape bonding material structure;

Figure 9 is a schematic representation of a tape bonding material structure including a heat conduction ring; and

Figure 10 is a schematic representation of a tape bonding structure including a nonconductive ring for strengthening the metal fingers.

The present invention is particularly directed to an electronic circuit assembly and comprising a semiconductor die 12 having terminal pads 14 on a top surface 16 thereof. A lead frame 18 is disposed adjacent the semiconductor die and is adapted to be electrically connected to the die. The electrical connection means 20 is provided to directly interconnect the terminal pad 14 to the lead frame 18. The electrical connection device comprises a transport tape 22 which may be a biclad or triclad composite as described hereinbelow. The claddings are chosen so that components of the transport tape are strong to resist deformation during material handling, soft to improve the bondability to the lead frame and resistant to the formation of intermetallics between the tape and the semiconductor die.

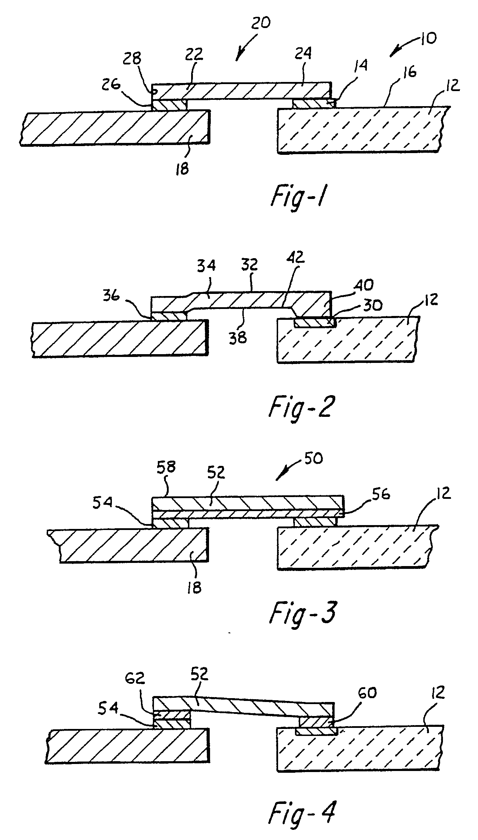

As can be seen in Figure 1, the transport tape 22 is disposed in the electronic circuit assembly 10 with one end of member 24 bonded to the terminal pad 14 and a second member 26, clad to member 24, bonded to lead frame 18.

The lead frame material as mentioned hereinabove has a relatively high strength and is accordingly formed of a relatively hard material such as copper-nickel alloys C19400 or C19500. At the same time, it is desirable to provide a soft surface in the area to which the bond to the tape is made. Thick plating or cladding of the lead frame surface in that area to form this soft surface is undesirable because of the inherent cost. Therefore, it may be desirable that the tape area which is bonded to the lead frame be substantially softer than the lead frame material. The transport tape is also bonded at the other end to a bonding pad which is formed of a soft metal or alloy such as aluminum. However, the highest temperature area during the operation of the semiconductor die is on the face of the die. Depending upon the type of service, there may be concern for potential formation of intermetallics between the aluminum on the surface of the die and the material from which the tape is manufactured. This may be of a particular concern with bipolar integrated circuits which generally operate at relatively high temperatures.

Figure 1 represents a unique system to overcome the problem of providing a soft bonding surface between the transport tape 22 and the lead frame 18 on one side while reducing the potential formation of intermetallics between an aluminum terminal pad 14 and the transport tape on the other side. The tape 22 is manufactured from a binary composite. One component of the composite is a nickel containing material 24 which may consist essentially of 20% up to 100% nickel and the remainder copper; more preferably, 20 to 40% nickel and the remainder copper. The important advantage of using a material containing nickel is that when bonded to aluminum containing elements, there is a significant reduction in the level of copper-aluminum intermetallic compounds. More details of this advantage are described in EP-A-0116 844. Also, the material 24 has a yield strength of at least about 60,000 psi (about 4,100 bar). A second component 26 of material having a yield strength of less than about 40,000 psi (about 2,700 bar) enhances the bonding with the lead frame 18. Preferably, the second component 26 is formed of a material consisting essentially of copper. The component 26 may be clad onto the copper-nickel component 24. Then, the tape is etched and the copper removed from the area to which the die 12 is to be bonded. This allows the surface of the tape which is to be presented to the aluminum bump 14 on the die to preferably be a copper-nickel surface. At the same time, the surface of the tape presented to the hard lead frame is a soft material such as copper.

In order to provide the component 26 in its softest possible condition, the tape 22 may be annealed at a temperature above the annealing temperature of component 26 and below that of component 24 so that the component 24 remains hard while the component 26 is soft. For instance, the component 26 may be formed of copper or a copper alloy, such as alloy C11000, which may be annealed so that the yield strength is under 40,000 psi (2,700 bar) while the strength of the copper-nickel component 24 is above about 60,000 psi (4,100 bar). Since the copper-nickel portion of the tape remains hard, the tape leads or fingers are relatively resistant to deformation during assembly and make it possible to increase the separation between the tips of the lead frame 18 and the semiconductor die 12. This is of an important advantage in the case of high count lead devices as mentioned above.

Figure 2 is essentially the same as Figure 1 except that the bonding pad 30 on the die 12 is essentially flush with the top surface of the die. This necessitates the use of a bumped tape 32. The tape is again made from a biclad composite preferably comprising a copper-nickel component 34 and a copper component 36. As with the embodiment of Figure 1, each of these components may be chosen with different compositions as long as their yield strengths and ability to bond to the semiconductor and the lead frame are not impaired. A portion 38 of the element 34 is removed by any desirable method such as etching to leave a bump 40 extending outward from the surface 42 of the tape. Preferably, this bump extends outward from the surface 42 at least .001" (0.025 mm) in order that the tape 32 does not contact the surface of the semiconductor 12. It should be noted that the component 36 of Figure 2 has a thickness of at least about .0001" (0.0025 mm) as does the equivalent component 26 in Figure 1.

The electrical conductivity of copper-nickel alloys within the range specified above is only in the order of 4 to 8% IACS. To compensate for this poor conductivity, the cross section of tape leads is typically substantially larger than the cross section of gold or aluminum bonding wires. For example, the minimum cross section of the tape leads may be approximately 12 square mils (0.0075 mm$^2$) as compared to the cross section of a .001" (0.025mm) diameter bonding wire which is only .79 square mils (0.0005mm$^2$), a ratio of 15:1. Thus, the current carrying capacity of a copper-nickel tape lead is approximately equal to that of a .001" (0.025 mm) gold bonding wire. However, as the semiconductors become more complex and the dies become smaller, the ability to form smaller tape leads which have adequate current carrying capacity as well as heat dissipation abilities becomes more important.

Referring to Figure 3, there is shown an alternative embodiment wherein the advantages discussed with respect to the first embodiment shown in Figures 1 and 2 are maintained while attaining improved electrical and thermal conductivity at the same time. In this embodiment, the tape 50 is manufactured from a three layer composite. The thickest component 52 is a high conductivity material which is preferably an anneal resistant high conductivity copper alloy, such as, for example, copper alloys C19400 or C15100. The alloy has a high yield strength of a minimum of about 60,000 psi. Also, the alloy has to have an anneal resistance so that it does not anneal at the temperature that the soft component 54 (corresponding to component 26 in Figure 1) anneals. Also, the component 52 must have a high conductivity which is at least twice that of copper-nickel and, preferably, 50% or more IACS. The intermediate layer 56 of the composite is a copper-nickel alloy which is substantially the same as component 24 described in conjunction with the embodiment of Figure 1. The outer layer 54 is preferably etched away except on the end portion 58 of the internal lead which is to be bonded to the lead frame 18. As described with regards to the embodiments or Figures 1 and 2, the tape 50 may be annealed so as to render the copper area 54 as soft as possible without affecting the remainder of the tape.

Referring to Figure 4, there is shown an embodiment which is substantially the same as Figure 3 except that the copper-nickel component has a central portion etched away so that only end pads 60 and 62 of the copper-nickel substrate remain.

In certain operating environments, the subsequent processing or operating temperature to which the tape-die interface will be exposed will not create the potential formation of copper-aluminum intermetallics at this interface. In that event, the copper-nickel alloy material which is advantageously bonded to the aluminum terminal pad 73 is not required.

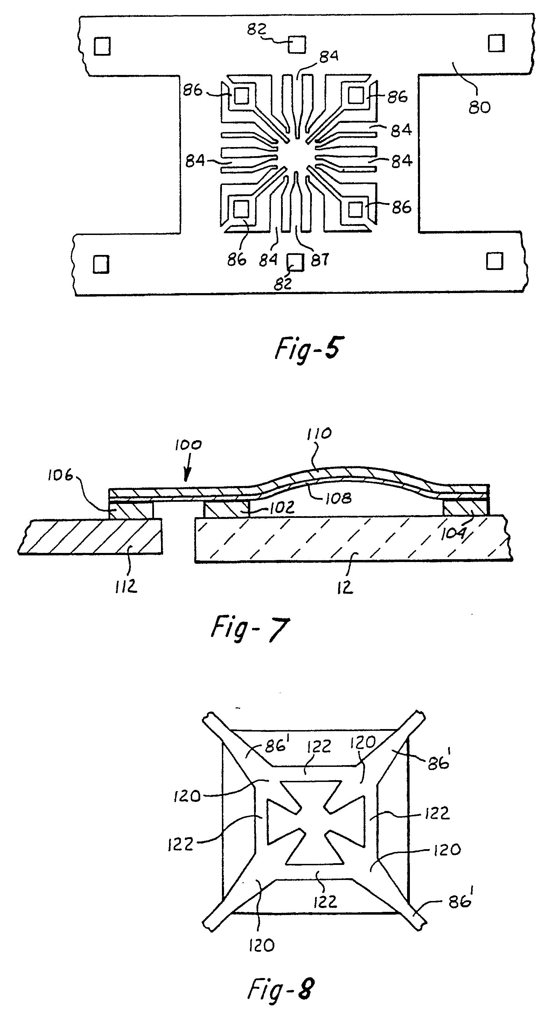

Figure 5 shows a fragment of metal tape 80 which has been prepared to accommodate a semiconductor device 12. Only one pattern is shown, however, it is understood that a plurality of such patterns exist along the tape. Holes 82 act to index and transport the tape in the following process. A plurality of metal fingers 84, 86 and 87 are configured to mate with the bonding pads on semiconductor device 12. The metal of tape 80 is preferably a composite of the materials as described in the embodiments illustrated in Figures 1 through 4. It is preferred that each finger includes a raised portion at the end which bonds to the semiconductor. However, it is also within the scope of the present invention to prepare flat tape and provide the terminal bumps on the semiconductor device itself. An important advantage of using the transport tape is that all of the tape fingers 84 may be gang bonded at the same time to the bonding pads of semiconductor device 12. Any number of fingers 84 may be used and configured in any desirable manner. For example, any of the fingers, such as fingers 87 may be a longer length so as to reach any bonding terminal on the die as desired. The four corner fingers 86 are discussed in detail below. If desired, an insulating film composed of, for example, a two-mil (0.05 mm) thick polyimide (such as Dupont, KAPTON polyimide) may be coated on one or both faces of the tape with an adhesive such as B-staged epoxy. The film is preferably not deposited on the strip sections wherever the leads are to be bonded.

Referring to Figure 6, there is shown a section of a typical Quad Pak lead frame 90. The central pad area 92, to which the die 12 is to be attached, is supported at the corners by support bars 94 which are not connected to external leads. Instead, the corner fingers 94 end at the dam bars 98. Once the lead frame with the semiconductor die bonded thereto is placed into a housing and encapsulated with a standard encapsulating material, the lead frame material is trimmed off so that only the fingers 96 are abutting out from the package. However, the corner fingers 94 are on the inner side of the dam bar, closer to the die and, therefore, do not jut out from the package. This feature enables these corner bars to be quite suitable to use as heat dissipation leads as explained below. It should be noted that it is within the terms of the present invention to allow the corner leads to extend from the package if such a configuration were desired.

To optimize heat dissipation from the die, one or more of the tape fingers may be bonded to pads on the die more central than those bonding pads distributed around the periphery. This requires that the unsupported cantilver span to be made by the tape finger, between the lead frame and the die, be quite long as compared to the normal length between the lead frame and the terminal pad near the periphery of the die. In principle, this requires that the tape material have the characteristics of both high strength and high thermal conductivity.

Another solution is to provide an arch in the tape material so that the tape finger does not have a tendency to contact the die except where it is bonded to the terminal. Shaping the fingers after etching is quite impractical. Therefore, it is thought that after the application of the photoresist pattern and its development, the unetched tape be formed before the etching process. Then the tape finger can be bonded to the lead frame and the die in the shaped condition.

A manufacturing consideration to be taken into account is that the end of the tape finger which is to be bonded to the terminal pad near the center of the die must be coplanar with those bonded to the peripheral bonding pads. A solution to this problem is to confine the shaping of the finger to the area between the pheripheral terminal pads and the inboard terminal pads.

Referring to Figure 7, TAB tape finger 100 is arched away from the die 12 between the terminal pads 102 and 104. This acts to limit the extent of the unsupported span reaching the more centrally located pad 104. At the same time, it allows for improved heat dissipation from the central area of the pad. Using any of the clad tape materials described hereinabove, the tape finger 100 is preferably formed of materials to give it the needed characteristics of high strength, good bondability and substantial elimination of the potential intermetallics. For example, cladding 106 is copper like cladding 26 of Figure 1. The cladding 108, bonded to the terminal pads, is a copper-nickel material like cladding 24 of Figure 1. The principal component 110 is a high strength, high conductivity copper alloy like cladding 52 of Figure 3. The particular shape of the arch between the terminal pads 102 and 104 is a matter of design and can be of any desired configuration. Also, it is within the terms of the present invention to form the arch between the lead frame 112 and the centrally located terminal pad 104 on the die 12 and forego the connection of the finger to the peripheral pad 102 as shown.

As mentioned hereinabove, the support bars 94 of the Quad Pak 90 illustrated in Figure 6 are not connected to external leads. These support bars are typical of DIP lead frames which use supports for the die pads. It is within the terms of the present invention to improve the heat dissipation from a semiconductor die by bonding one or more of the corner fingers 86 of the transport tape 80 between the surface of the semiconductor chip and the support bars 94 on the lead frame 90. This may be accomplished by bonding the inner ends of the fingers 86 to either a peripheral terminal pad on a chip or to an inboard pad and may further include the provision of an arch as described with regards to the embodiment illustrated in Figure 8.

Referring to Figure 8, corner fingers 86' formed of any cladding described above are thermal dissipation leads. It may be desirable to form each of them with an arch, as seen in Figure 7 and to join the arched portions of each of the thermal leads together near the apex of the arch. Each of the thermal leads 86' may be an extension of the corner leads 86 as shown in Figure 5. The arched sections 120 of the fingers 86' may be joined by a connecting bar 122. This connecting bar provides an additional advantage in that it strengthens the dissipation leads 86' and helps prevent them from collapsing under the pressure exerted by the molding compound. Further, the thermal dissipation leads may be formed in any configuration and, preferably, wider within the area of the chip as compared to the area external to the chip. The increase in the width of the fingers 86' improves their rigidity and their heat dissipation characteristics. Of course, they are preferably tapered back to a smaller dimension at the point at which they are bonded to the terminal leads on the die so as to minimize the extent of the surface area on the die to be occupied by the terminal bonding pads. Although the configuration of the connecting bars 122, shown in Figure 8, is substantially square, it is also within the terms of the present invention to form it in any desired shape and between any number of transport tape fingers. It should also be noted that although Figure 8 only shows the corner fingers attached to the die, any number of other fingers may be attached to terminal pads near the periphery of the die as described hereinabove.

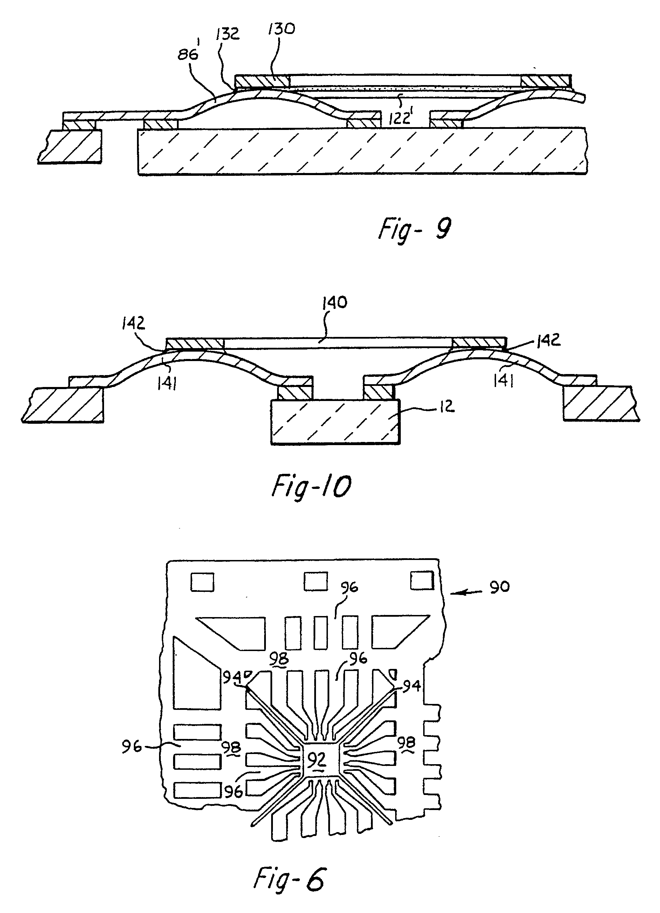

The embodiment of Figure 9 includes ring 130, of conductive material such as copper, attached to the connecting bars 122 of the thermal dissipation leads 86' illustrated in Figure 8. The ring 130 may be attached to the connection bars by any suitable means such as a conductive adhesive 132 composed of any conventional metal powdered dope epoxy. The shape of the ring 130 could be of any desired configuration such as a donut shape or a hollow square. The ring may act as a supplementary heat sink or heat spreader within the package. If desired, the ring could actually form an outer surface of the final package and thereby be even more effective in dissipating heat.

The combination of the tape fingers joined by the connections bars and with or without the ring could be connected through the lead frame so as to be electrically grounded. In that instance, a Faraday cage would be formed which would assist in protecting the die from electromagnetic interference.

In certain applications, the semiconductor die size is minimized and the span between the lead frame and the periphery of the die is so large that the tape fingers would have a tendency to sag and possibly contact the die and short out the circuit. The use of relatively high strength claddings for the tape finger leads, as described in the embodiments illustrated in Figures 1 through 4, would tend to mitigate this problem. Alternatively, or in conjunction with, the leads 141 may be arched between the lead frame and the die as shown in Figure 10. As described above, the forming of the arch in the lead fingers 141 would preferably occur before the transport tape is etched into the desired configuration. To reinforce the arches, a ring 140 having any desired shape may be bonded to the top of the arches using a nonconductive adhesive 142 such as epoxy. To improve heat dissipation the ring could be made from a conductive material and the adhesive could be thermally but not electrically conductive. It is also within the terms of the present invention to eliminate the ring 140.

The claddings may be formed by any conventional technique such as the POSIT-BOND bonding process.

It is apparent that there has been provided in accordance with this invention a tape bonding material and structure for electronic circuit fabrication.

## Claims

1. An electronic circuit assembly (10, comprising a semiconductor die (12) having at least one pad (14) on a surface (16) thereof; a lead frame (18) disposed adjacent said semiconductor die (12) adapted to be electrically connected to said semiconductor die (12); and electrical connection means (20; 32; 50) for directly interconnecting said at least one terminal pad (14) to said lead frame (18), said electrical connection means (10) comprising: a transport tape (22, 32; 52) including: a first layer (24; 34; 56; 60; 62) formed from a nickel containing material; a second layer (26; 36; 54) formed from a copper containing material; said first and second layers (24, 34, 56, 60, 62; 26, 36, 54) being bonded together; and a plurality of fingers (84, 86, 87), at least one of said fingers being bonded at a first end to said terminal pad (14) and at a second end to said lead frame (18) whereby said first layer (24, 34, 56, 60, 62) is bonded to said terminal pad and said second layer (26, 36, 54) is bonded to said lead frame (18).

2. The assembly of claim 1 characterized by said first layer (24) being 20 % up to 100 % nickel and the remainder copper.

3. The assembly of claim 1 or 2 characterized by said first layer (24) having a yield strength of at least about 60,000 psi (about 4,100 bar) and said second layer having a yield strength of less than about 40,000 psi (about 2,700 bar).

4. The assembly (50) of any of claims 1 to 3 further characterized by a third layer (52) formed of a copper alloy having a yield strength of at least 60,000 psi (about 4,100 bar) and a conductivity of at least 50 % IACS, said third layer (24) being bonded to said first layer.

5. The assembly of claim 1, wherein the semiconductor die (12) has at least a first terminal pad (102) disposed adjacent an edge on the top surface thereof, and at least a second terminal pad (104) disposed closer to the center of said die on the top surface thereof; characterized in that the transport tape has a plurality of fingers, at least one of said fingers being bonded at a first end to said first and second terminal pads, said first end being curved between said first and second pads to be out of contact with said die, said at least one of said fingers further having a second end bonded to said lead frame.

6. The assembly of claim 5 characterized in that a third layer (110) of said transport tape is formed of a copper containing material with a yield strength of at least about 60,000 psi (about 4,100 bar) and a conductivity of at least about 50% IACS.

7. The assembly of claim 6 further characterized in that the first layer (108) is bonded to the third layer (110) and directed to said first and second terminal pads (102, 104) on said semiconductor die.

8. The assembly of claim 7 further characterized in that the second layer (106) is directly bonded to said first layer (108) and to said lead frame (112).

9. The assembly of any of claims 5 to 8 characterized by said connection means further including at least a second finger substantially the same as said first finger between said lead frame (112) and said semiconductor die (12); and connection bar means (122) connecting said first and second finger (86') to enhance the heat dissipation from said semiconductor die.

10. The connection means of claim 9 further characterized by a ring means (130, 140) affixed to at least said first and second fingers (86', 141) for strengthening said first and second fingers and improving the heat transfer therefrom.

11. The connection means of claim 9 or 10 further characterized by a conductive bonding means (132, 142) between said first and second fingers (86', 141) and said ring means for bonding said ring means (130, 140) to said first and second fingers.

## Revendications

1. Assemblage de circuit électronique (10) comprenant
une pastille en semi-conducteur (12) ayant au moins un plot (14) sur une surface (16) de celle-ci;
une grille de connexion (18) disposée de manière adjacente à la dite pastille en semi-conducteur (12) et prévue pour être reliée électriquement à la dite pastille en semi-conducteur (12); et
des moyens de connexion électriques (20; 32; 50) destinés à interconnecter directement au moins un plot de borne (14) à la dite grille de connexion (18), les dits moyens de connexion électriques (10) comprenant :
une bande de transport (22; 32; 52) comprenant :
une première couche (24; 34; 56; 60; 62) formée à partir d'un matériau contenant du nickel;
une deuxième couche (26; 36; 54) formée à partir d'un matériau contenant du cuivre;
les dites première et deuxième couches (24, 34, 56, 60, 62; 26, 36, 54) étant reliées ensemble; et
plusieurs doigts (84, 86, 87), au moins l'un des dits doigts étant reliés à une première extrémité au dit plot de borne (14) et à une deuxième extrémité à la dite grille de connexion (18), la dite première couche (24, 34, 56, 60, 62) étant reliée au dit plot de borne et la dite deuxième couche (26, 36, 54) étant reliée à la dite grille de connexion (18).

2. Assemblage selon la revendication 1, caractérisé en ce que la dite première couche (24) est de 20 % à 100 % en nickel et le reste en cuivre.

3. Assemblage selon la revendication 1 ou 2, caractérisé en ce que la dite première couche (24) a une limite élastique de au moins environ 60000 psi (environ 4100 bar) et la dite deuxième couche a une limite élastique de moins de environ 40000 psi (environ 2700 bar).

4. Assemblage (50) selon l'une quelconque des revendications 1 à 3, caractérisé par une troisième couche (52) formée dans un alliage de cuivre ayant une limite élastique de au moins 60000 psi (environ 4100 bar) et une conductivité de au moins environ 50 % IACS, la dite troisième couche (24) étant reliée à la dite première couche.

5. Assemblage selon la revendication 1, dans lequel la pastille en semi-conducteur (12) possède au moins un premier plot de borne (102) disposé de manière adjacente à un bord sur la surface supérieure de celle-ci, et au moins un deuxième plot de borne (104) disposé plus près du centre de la dite pastille à la surface supérieure de celle-ci; caractérisé en ce que la bande de transport a plusieurs doigts, au moins un des dits doigts étant relié à une première extrémité aux dits premier et deuxième plots de bornes, la dite première extrémité étant incurvée entre les dits premier et deuxième plots de bornes de façon à être hors de contact de la dite pastille, le dit doigt ayant en outre une deuxième extrémité reliée à la dite grille de connexion.

6. Assemblage selon la revendication 5, caractérisé en ce que une troisième couche (110) de la dite bande de transport est formée dans un matériau contenant du cuivre avec une limite élastique de au moins environ 60000 psi (environ 4100 bar) et une conductivité de au moins environ 50 % IACS.

7. Assemblage selon la revendication 6, caractérisé en outre en ce que la première couche (108) est reliée à la troisième couche (110) et dirigée vers les dits premier et deuxième plots de bornes (102, 104) sur la dite pastille en semi-conducteur.

8. Assemblage selon la revendication 7, caractérisé en outre en ce que la deuxième couche (106) est directement reliée à la dite première couche (108) et à la dite grille de connexion (112).

9. Assemblage selon l'une quelconque des revendications 5 à 8, caractérisé en ce que les dits moyens de connexion comportent en outre au moins un deuxième doigt substantiellement le même que le dit premier doigt entre la dite grille de connexion (112) et la dite pastille en semi-conducteur (12); et des moyens de barre de connexion (122) reliant le dit premier et deuxième doigt (86') afin d'améliorer la dissipation de chaleur depuis la dite pastille en semi-conducteur.

10. Moyens de connexion selon la revendication 9, caractérisé en outre par des moyens de bague (130, 140) fixés au moins aux dits premier et deuxième doigts (86', 141) afin de renforcer les dits premier et deuxième doigts et améliorer le transfert de chaleur depuis ceux-ci.

11. Moyens de connexion selon la revendication 9 ou 10, caractérisé en outre par des moyens de liaison conducteurs (132, 142) entre les dits premier et deuxième doigts (86', 141) et les dits moyens de bague de façon à relier les dits moyens de bague (130, 140) aux dits premier et deuxième doigts.

## Ansprüche

1. Elektronische Schaltungsanordnung (10), mit einem Halbleiterchip (12), der wenigstens eine Anschlußfläche (14) auf einer seiner Oberflächen (16) aufweist; mit einem nahe dem Halbleiterchip (12) angeordneten Leiterrahmen (18), der mit dem Halbleiterchip (12) elektrisch verbindbar ist; und mit einer elektrischen Verbindungseinrichtung (20; 32; 50) zum direkten Verbinden der wenigstens einen Anschlußfläche (14) mit dem Leiterrahmen (18), wobei die elektrische Verbindungseinrichtung (10) aufweist: ein Transportband (22, 32; 52) beinhaltend: eine erste, aus einem nickelhaltigen Material gebildete Schicht (24; 34; 56; 60; 62); eine zweite, aus einem kupferhaltigen Material gebildete Schicht (26; 36; 54); wobei die erste und die zweite Schicht (24, 34, 56, 60, 62; 26, 36, 54) miteinander verbunden sind; und eine Mehrzahl von Fingern (84, 86, 87), von denen wenigstens ein Finger an einem ersten Ende mit der Anschlußfläche (14) verbunden ist und an einem zweiten Ende mit dem Leiterrahmen (18) verbunden ist, wodurch die erste Schicht (24, 34, 56, 60, 62) mit der Anschlußfläche verbunden ist und die zweite Schicht (26, 36, 54) mit dem Leiterrahmen (18) verbunden ist.

2. Anordnung nach Anspruch 1,
dadurch gekennzeichnet, daß die erste Schicht (24) aus 20 % bis 100 % Nickel und zum Rest aus Kupfer besteht.

3. Anordnung nach Anspruch 1 oder 2,
dadurch gekennzeichnet, daß die erste Schicht (24) eine Streckfestigkeit von wenigstens ca. 60.000 psi (Pfund pro Quadratzoll) (ca. 4.100 bar) aufweist und die zweite Schicht eine Streckfestigkeit von weniger als ca. 40.000 psi (ca. 2.700 bar) aufweist.

4. Anordnung (50) nach einem der Ansprüche 1 bis 3,
weiterhin gekennzeichnet durch eine dritte Schicht (52), die aus einer Kupferlegierung gebildet ist und eine Streckfestigkeit von wenigstens 60.000 psi (ca. 4.100 bar) und eine Leitfähigkeit von wenigstens 50 % IACS besitzt, wobei die dritte Schicht (24) mit der ersten Schicht verbunden ist.

5. Anordnung nach Anspruch 1, wobei der Halbleiterchip (12) wenigstens eine erste Anschlußfläche (102) ,die nahe bei einer Kante auf der oberen Oberfläche desselben angeordnet ist, sowie wenigstens eine zweite Anschlußfläche (104) aufweist, die näher bei der Mitte des Chips auf der oberen Oberfläche desselben angeordnet ist;
dadurch gekennzeichnet, daß das Transportband eine Mehrzahl von Fingern aufweist, von denen wenigstens ein Finger an einem ersten Ende mit der ersten und der zweiten Anschlußfläche verbunden ist, wobei das erste Ende zwischen der ersten und der zweiten Anschlußfläche derart gekrümmt ist, daß es außer Berührung mit dem Chip ist, und wobei der genannte, wenigstens eine Finger mit einem zweiten Ende mit dem Leiterrahmen verbunden ist.

6. Anordnung nach Anspruch 5,
dadurch gekennzeichnet, daß eine dritte Schicht (110) des Transportbands aus einem kupferhaltigen Material mit einer Streckfestigkeit von wenigstens ca. 60.000 psi (ca. 4.100 bar) und einer Leitfähigkeit von wenigstens ca. 50 % IACS gebildet ist.

7. Anordnung nach Anspruch 6,

weiterhin dadurch gekennzeichnet, daß die erste Schicht (108) mit der dritten Schicht (110) verbunden ist und der ersten und der zweiten Anschlußfläche (102, 104) auf dem Halbleiterchip zugewandt gegenüberliegt.

8. Anordnung nach Anspruch 7,
weiterhin dadurch gekennzeichnet, daß die zweite Schicht (106) direkt mit der ersten Schicht (108) und dem Leiterrahmen (112) verbunden ist.

9. Anordnung nach einem der Ansprüche 5 bis 8,
dadurch gekennzeichnet, daß die Verbindungseinrichtung weiterhin wenigstens einen zweiten Finger aufweist, der mit dem ersten Finger zwischen dem Leiterrahmen (112) und dem Halbleiterchip (12) im wesentlichen identisch ist; und daß eine Verbindungsleisteneinrichtung (122) vorgesehen ist, die den ersten und den zweiten Finger (86') zur Steigerung der Wärmeabführung von dem Halbleiterchip miteinander verbindet.

10. Verbindungseinrichtung nach Anspruch 9,
weiterhin gekennzeichnet durch eine wenigstens an dem ersten und dem zweiten Finger (86', 141) angebrachte Ringeinrichtung (130, 140) zum Verstärken des ersten und des zweiten Fingers sowie zur Verbesserung des Wärmetransfers von diesen.

11. Verbindungseinrichtung nach Anspruch 9 oder 10,
weiterhin gekenzeichnet durch eine leitfähige Verbindungseinrichtung (132, 142) zwischen dem ersten und dem zweiten Finger (86', 141) und der Ringeinrichtung zum Verbinden der Ringeinrichtung (130, 140) mit dem ersten und dem zweiten Finger.

Fig-1

Fig-2

Fig-3

Fig-4

Fig-5

Fig-7

Fig-8

Fig-9

Fig-10

Fig-6